# EUROPEAN PATENT APPLICATION

(11) **EP 4 518 050 A1**
(43) Date of publication of application: **05.03.2025**
(21) Application number: 23854169.2
(22) Date of filing: 14.07.2023
(51) Int. Cl.: H01S 5/42, H01S 5/0233

(54) **LINEAR-LIGHT-SPOT LIGHT SOURCE EMISSION DEVICE AND APPARATUS**

(30) Priority: 18.08.2022 CN 202210993240
(71) Applicant: Focuslight Technologies Inc., Xi'an, Shaanxi 710077 (CN)
(72) Inventor: ZHOU, Dandan, Xi'an, Shaanxi 710077 (CN); CHONG, Hongtao, Xi'an, Shaanxi 710077 (CN); FAN, Yingmin, Xi'an, Shaanxi 710077 (CN); YUAN, Ke, Xi'an, Shaanxi 710077 (CN)
(74) Representative: Ipside
(86) International application number: PCT/CN2023/107516
(87) International publication number: WO 2024/037264

(57) **Abstract**

The present application provides a line beam light source emitting device and equipment, belonging to the field of laser technology. The device includes a plurality of vertical cavity surface emitting laser chips and a circuit board, and the circuit board includes a driving circuit; each vertical cavity surface emitting laser chip includes a light emitting area; the light emitting area of each vertical cavity surface emitting laser chip includes a first edge and a second edge; each vertical cavity surface emitting laser chip is arranged side by side along the first edge of the light emitting area and fixed on the circuit board, and the first pole and the second pole of each vertical cavity surface emitting laser chip are respectively connected to the driving circuit, and each vertical cavity surface emitting laser chip is connected through the driving circuit, and the driving circuit drives each vertical cavity surface emitting laser chip to emit laser . The present application can achieve the effect of improving the reliability of the line beam light source emitting device and reducing power attenuation when the working environment temperature varies in a large range.

## Description

### Cross-Reference To Related Applications

This application claims priority to a Chinese patent application with application number 202210993240.0 filed with the Chinese Patent Office on August 18th , 2022 and entitled "Line beam light source emitting device and equipment ", the entire contents of which are incorporated by reference into this application.

### Technical Field

The present application relates to the field of laser technology, and in particular to a line beam light source emitting device and equipment.

### Background of the Invention

With the rapid development of laser technology, people often use lasers in industrial or electronic fields for distance detection, depth detection, laser communication, laser lighting, etc., and the laser can also be adjusted into a line spot according to actual needs.

In the related technology, generally, multiple edge emitting lasers (EEL) can be selected to form a high-power line spot device of thousands of watts. Multiple EELs are used to emit multiple laser beams to form bright line spots, cross spots, surface spots and other light sources to achieve the purposes of illumination, detection and communication.

However, since the spectral drift coefficient of EEL varies greatly with temperature, when the working environment temperature difference is large, the spectral position collected by the instrument will change, which will affect the accuracy of detection and communication. In addition, the power attenuation of EEL in a wide temperature range is more serious and may even reach 50 % power attenuation. Therefore, when the working environment temperature changes in a large range, the solutions in the related art have the problems of poor reliability and large power attenuation.

### Summary of the Invention

The purpose of the present application is to provide a line beam light source emitting device and equipment, which can improve the reliability of the line beam light source emitting device and reduce power attenuation when the working environment temperature varies over a large range.

The embodiment of the present application is implemented as follows:
According to a first aspect of an embodiment of the present application, a line beam light source emitting device is provided, the device comprising a plurality of vertical cavity surface emitting laser (Vertical Cavity Surface Emitting Laser, referred to as VCSEL) chips and a printed circuit board (Printed Circuit Board, referred to as PCB), wherein the printed circuit board comprises a driving circuit.

Each of the vertical cavity surface emitting laser chips includes a light emitting area, the light emitting area includes a plurality of light emitting points, and each of the light emitting points is used to emit laser light.

The light emitting area of each of the vertical cavity surface emitting laser chips comprises a first edge and a second edge, and the length of the first edge is greater than the length of the second edge.

Each of the vertical cavity surface emitting laser chips is arranged side by side along a first edge of the light emitting area and fixed on the circuit board. The first pole and the second pole of each of the vertical cavity surface emitting laser chips are respectively connected to the driving circuit, and the driving circuit drives each of the vertical cavity surface emitting laser chips to emit laser.

Optionally, the light emitting area of each of the vertical cavity surface emitting laser chips is a rectangular area.

Optionally, the device further comprises a sub-heat sink.

The sub-heat sink is fixed on the circuit board, and each of the vertical cavity surface emitting laser chips is arranged side by side along the first edge of the light emitting area and bonded to the sub-heat sink.

The first pole and/or the second pole of each of the VCSEL chips is connected to the driving circuit through the sub-heat sink.

Optionally, a first surface of the sub-heat sink has a plurality of pad groups, the sub-heat sink also has a plurality of via groups, and a second surface of the sub-heat sink abuts against a top surface of the circuit board.

Each of the pad groups includes a first pad, each of the via groups includes a first via hole, and each of the first via holes is provided with a first conductive channel.

Each of the first via holes passes through the sub-heat sink, and the size of each of the first pads is larger than the size of each of the first via holes; each of the first via holes is used to connect the first pole of each of the vertical cavity surface emitting laser chips to the circuit on the circuit board.

Optionally, each of the pad groups further includes at least one second pad, each of the via groups further includes at least one second via hole, and each of the second via holes is provided with a second conductive channel.

Each of the second pads is located at least on one side of the first pad, and each of the second pads is not connected to each of the first pads.

Each of the second via holes passes through the sub-heat sink, a size of each of the second pads is larger than a size of each of the second via holes, and each of the second via holes is used to connect the second pole of each of the vertical cavity surface emitting laser chips to the circuit on the circuit board.

Optionally, the device further comprises an optical shaping module.

The optical shaping module is arranged at one side of the light emitting area of each of the vertical cavity surface emitting laser chips and is used to collimate and/or homogenize the laser emitted by each of the vertical cavity surface emitting laser chips in a first direction and/or a second direction, wherein the first direction is perpendicular to the second direction.

Optionally, a first electrode of each of the VCSEL chips is connected to a first common point on the driving circuit, and a second electrode of each of the VCSEL chips is connected to a second common point on the driving circuit.

Optionally, the first pole of the first vertical cavity surface emitting laser chip and the second pole of the second vertical cavity surface emitting laser chip are connected to a third common point on the driving circuit so that the first vertical cavity surface emitting laser chip and the second vertical cavity surface emitting laser chip are connected in series, wherein the first vertical cavity surface emitting laser chip and the second vertical cavity surface emitting laser chip are two adjacently arranged vertical cavity surface emitting laser chips among the vertical cavity surface emitting laser chips.

Optionally, the length of the second edge of the light emitting area of each of the VCSEL chips is greater than or equal to 30 micrometers and less than or equal to 100 micrometers.

According to a second aspect of the embodiments of the present application, a line beam light source emitting device is provided. The device comprises a shell and the line beam light source emitting device described in the first aspect, wherein the shell is used to fix the line beam light source emitting device.

The beneficial effects of the embodiments of the present application include:
An embodiment of the present application provides a line beam light source emitting device, which includes a plurality of VCSEL chips and a PCB, and the PCB includes a driving circuit. Each VCSEL chip includes a light emitting area, and the light emitting area includes a plurality of light emitting points, each of which is used to emit laser. The light emitting area of each VCSEL chip includes a first edge and a second edge. Each VCSEL chip is arranged side by side along the first edge of the light emitting area and fixed on the PCB, and the first pole and the second pole of each VCSEL chip are respectively connected to the driving circuit, and the driving circuit drives each VCSEL chip to emit laser.

Among them, the first pole and the second pole of each VCSEL chip can be connected to the driving circuit respectively, and each VCSEL chip is connected through the driving circuit. When the first pole and the second pole of each VCSEL chip are connected to the driving circuit, each VCSEL chip can be connected to the driving circuit, and the driving circuit supplies power to each VCSEL chip, and the driving circuit can also control the duration, frequency, intensity and other parameters of the laser emitted by each VCSEL chip. Since the bottom surface of the VCSEL chip is fixed on the top surface of the PCB, the first pole of each VCSEL chip can be directly connected to the driving circuit in the PCB, so that the current conduction path can be shortened and the parasitic inductance of each VCSEL chip when working can be reduced, so that the line beam light source emitting device can obtain a short pulse width.

When the driving circuit of the PCB supplies power to each VCSEL chip, each VCSEL chip can be powered on to emit laser light. Since each VCSEL chip is arranged side by side along the first edge of the light emitting area, that is, arranged side by side along the length direction of the light emitting area, it can be ensured that the light emitting area of each VCSEL chip in the line light beam light source emitting device can form a longer light emitting area in the direction of the first edge, and emitting laser light through this longer light emitting area can make the laser emitted by the line light beam light source emitting device form a line light spot. Arranging each VCSEL chip side by side along the first edge of the light emitting area can ensure that the divergence angle of the laser emitted by the line light beam light source emitting device in the slow axis direction will not be affected, so that the power of the line light beam light source emitting device when emitting laser light can be increased, and the high power of the line light beam light source emitting device can also be achieved.

Since the spectral drift coefficient of the VCSEL chip with temperature change is very small, and the power attenuation of the VCSEL chip is also low in a wide temperature range, generally less than 20%, and since the line light beam light source emitting device provided in the embodiment of the present application adopts a VCSEL chip, the spectral drift coefficient of the line light beam light source emitting device with temperature change will be relatively small, and the power attenuation in a wide temperature range will also be low. In this way, the reliability of the line light beam light source emitting device can be improved, and the power attenuation can be reduced when the working environment temperature changes in a large range.

In addition, when using the line beam light source emitting device for distance detection, depth detection, and laser communication, a receiving device is required to receive the laser emitted by each VCSEL chip. Since the power attenuation of the line beam light source emitting device is relatively low within a wide temperature range, the laser emitted by the line beam light source emitting device can be received by a receiving device with lower precision, thereby improving the versatility and universality of the line beam light source emitting device.

In this way, the reliability of the line beam light source emitting device can be improved, and the power attenuation can be reduced when the working environment temperature varies in a large range. In addition, the versatility and universality of the line beam light source emitting device can also be improved.

### Brief Description of the Drawings

To more clearly illustrate the technical solutions of the embodiments of the present application, the drawings required for use in the embodiments will be briefly introduced below. The following drawings only show certain embodiments of the present application and therefore should not be regarded as limiting the scope. For ordinary technicians in this field, other related drawings can be obtained based on these drawings without paying creative work.
FIG. 1 is a schematic structural diagram of a first type of line beam light source emitting device provided in an embodiment of the present application;
FIG. 2 is a schematic structural diagram of a second line beam light source emitting device provided in an embodiment of the present application;
FIG. 3 is a schematic structural diagram of a third type of line beam light source emitting device provided in an embodiment of the present application;
FIG. 4 is a schematic structural diagram of a fourth line beam light source emitting device provided in an embodiment of the present application;
FIG. 5 is a schematic structural diagram of a fifth line beam light source emitting device provided in an embodiment of the present application;
FIG. 6 is a schematic structural diagram of a sixth type of line beam light source emitting device provided in an embodiment of the present application;
FIG. 7 is a schematic structural diagram of a seventh line beam light source emitting device provided in an embodiment of the present application;
FIG. 8 is a schematic structural diagram of an eighth type of line beam light source emitting device provided in an embodiment of the present application;
FIG. 9 is a schematic structural diagram of a ninth type of line beam light source emitting device provided in an embodiment of the present application;
FIG. 10 is a schematic structural diagram of a tenth line beam light source emitting device provided in an embodiment of the present application;
FIG. 11 is a schematic structural diagram of an eleventh line beam light source emitting device provided in an embodiment of the present application;
FIG. 12 is a schematic structural diagram of an eleventh line beam light source emitting device provided in an embodiment of the present application;
FIG. 13 is a schematic structural diagram of a line beam light source emitting device provided in an embodiment of the present application; and
FIG. 14 is a flow chart of a packaging method for a line beam light source emitting device provided in an embodiment of the present application.

### Reference numerals:

101: VCSEL chip, 102: PCB , 103 : sub-heat sink, 104 : first pad, 105 : first via hole, 106 : second pad, 107 : second via hole, 108 : optical shaping module, 1081 : collimating lens, 1082 : homogenizing lens, 1083 : collimating lens, 1084 : homogenizing lens, 1085 : reflector, 109 : shell, D1 : first conductive channel, D2 : second conductive channel.

### Detailed Description of Embodiments

In order to make the purpose, technical solution and advantages of the embodiments of the present application clearer, the technical solution in the embodiments of the present application will be clearly and completely described below in conjunction with the drawings in the embodiments of the present application. Obviously, the described embodiments are part of the embodiments of the present application, rather than all the embodiments. The components of the embodiments of the present application described and shown in the drawings here can be arranged and designed in various configurations.

Therefore, the following detailed description of the embodiments of the present application provided in the accompanying drawings is not intended to limit the scope of the present application for protection, but merely represents selected embodiments of the present application. Based on the embodiments in the present application, all other embodiments obtained by ordinary technicians in this field without creative work are within the scope of protection of the present application.

It should be noted that similar reference numerals and letters denote similar items in the following drawings, and therefore, once an item is defined in one drawing, it does not require further definition and explanation in the subsequent drawings.

In the description of the present application, it should be noted that the terms "center", "upper", "lower", "left", "right", "vertical", "horizontal", "inner", "outer", etc. indicate positions or positional relationships based on the positions or positional relationships shown in the accompanying drawings, or the positions or positional relationships in which the invented product is usually placed when in use. They are only for the convenience of describing the present application and simplifying the description, and do not indicate or imply that the device or element referred to must have a specific position, be constructed and operated in a specific position, and therefore cannot be understood as a limitation on the present application. In addition, the terms "first", "second", "third", etc. are only used to distinguish the description, and cannot be understood as indicating or implying relative importance.

In addition, the terms "horizontal", "vertical" and the like do not mean that the components are required to be horizontal or suspended but can be slightly tilted. For example, "horizontal" only means that its direction is more horizontal than "vertical" and does not mean that the structure must be completely horizontal but can be slightly tilted.

In the description of this application, it should also be noted that, unless otherwise clearly specified and limited, the terms "set", "install", "connect", and "connect" should be understood in a broad sense, for example, it can be a fixed connection, a detachable connection, or an integral connection; it can be a mechanical connection or an electrical connection; it can be a direct connection, or it can be indirectly connected through an intermediate medium, or it can be the internal communication of two elements. For ordinary technicians in this field, the specific meanings of the above terms in this application can be understood according to specific circumstances.

In the related art, generally, multiple EELs can be selected to form a high-power line spot device of more than 1,000 watts, and multiple EELs are used to emit multiple laser beams to form bright line spots, cross spots, surface spots and other light sources to achieve the purpose of illumination, detection and communication. However, since the spectral drift coefficient of EEL with temperature change is large, then when the temperature difference of the working environment is large, the spectral position collected by the instrument will change, which will affect the accuracy of detection and communication, and the power attenuation of EEL in a wide temperature range is more serious, and even up to 50% power attenuation. In addition, EEL generally has only a few light emitting points to achieve high peak power. If some of the light emitting points on the EEL fail, it will cause great performance attenuation. Therefore, when the working environment temperature changes in a large range, the solutions in the related art have the problems of poor reliability and large power attenuation.

In addition, generally, conventional VCSEL chips are square chips, and the width and length of the light emitting area of such chips are equal, and the width and length of the light emitting area are generally larger. Therefore, the beam parameter product (BPP) of such VCSEL chips is larger, making it difficult to realize a line beam light source.

To this end, the embodiment of the present application provides a line beam light source emitting device, which includes multiple VCSEL chips and a PCB, the PCB includes a driving circuit, each VCSEL chip includes a light emitting area, the light emitting area includes multiple light emitting points, each light emitting point is used to emit laser, the light emitting area of each VCSEL chip includes a first edge and a second edge, each VCSEL chip is arranged side by side along the first edge of the light emitting area and fixed on the PCB, the first pole and the second pole of each VCSEL chip are respectively connected to the driving circuit, and the driving circuit drives each VCSEL chip to emit laser. It can achieve the effect of improving the reliability of the line beam light source emitting device and reducing power attenuation when the working environment temperature varies in a large range.

The embodiment of the present application is described by taking a line beam light source emitting device used in the field of electronics as an example, but it does not mean that the embodiment of the present application can only be used in the field of electronics for emitting line beam light sources.

The line beam light source emitting device provided in the embodiment of the present application is explained in detail below.

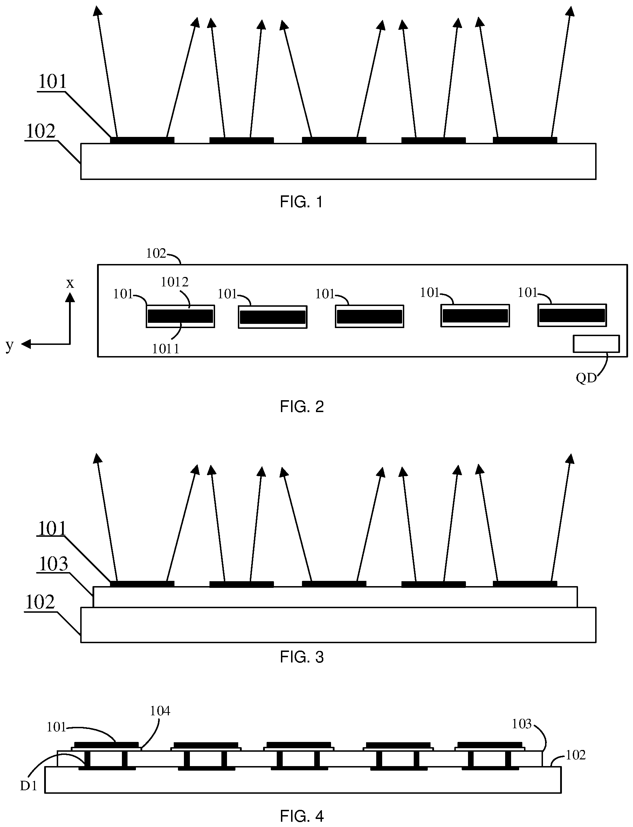

FIG. 1 is a schematic structural diagram of a first type of line beam light source emitting device provided in an embodiment of the present application. Referring to FIG. 1, an embodiment of the present application provides a line beam light source emitting device, the line beam light source emitting device comprises a plurality of VCSEL chips 101 , a PCB 102 , and the PCB 102 comprises a driving circuit.

Each VCSEL chip 101 includes a light emitting area, which includes a plurality of light emitting points, each of which is used to emit laser light.

The light emitting area of each VCSEL chip 101 includes a first edge and a second edge.

Each VCSEL chip 101 is arranged side by side along the first edge of the light emitting area and fixed on the PCB 102 . The first pole and the second pole of each VCSEL chip 101 are respectively connected to the driving circuit, and the driving circuit drives each VCSEL chip 101 to emit laser.

Optionally, the length of the first edge is greater than the second edge, that is, the light emitting area of each VCSEL chip 101 is a rectangular area. Then, the first edge is the long side of the light emitting area of each VCSEL chip 101, and the second edge is the short side of the light emitting area of each VCSEL chip 101.

Optionally, the driving circuit may be a circuit printed on the top surface of PCB 102, and the driving circuit may supply power to each VCSEL chip 101 to drive each VCSEL chip 101 to power on and operate. When each VCSEL chip 101 is powered on and operates, each VCSEL chip 101 may emit a laser.

The driving circuit can also control the output power of the laser emitted by each VCSEL chip 101, and control the parameters such as the duration, frequency, and intensity of the laser emitted by each VCSEL chip 101.

The driving circuit can also be used to connect to a power source, and the power source can output electric energy to the driving circuit. The driving circuit can be any possible circuit, and the embodiment of the present application does not limit this.

In addition, each VCSEL chip 101 has a first electrode and a second electrode. The first electrode of each VCSEL chip 101 is an electrode facing the PCB 102, and the second electrode of each VCSEL chip 101 is an electrode located on the same side as each light emitting area. In other words, the first electrode of each VCSEL chip 101 is located at the bottom surface of each VCSEL chip 101 , and the second electrode of each VCSEL chip 101 is located at the top surface of each VCSEL chip 101 .

Generally, if the first electrode of the VCSEL chip 101 is the cathode of the VCSEL chip 101 , then the second electrode of the VCSEL chip 101 is the anode of the VCSEL chip 101 ; if the first electrode of the VCSEL chip 101 is the anode of the VCSEL chip 101 , then the second electrode of the VCSEL chip 101 is the cathode of the VCSEL chip 101 .

Optionally, the length of the second edge of the light emitting area of each VCSEL chip 101 is greater than or equal to 30 microns and less than or equal to 100 microns. The diameter of each light emitting point in the light emitting area is less than or equal to 33 microns. In addition, the length of the second edge of the light emitting area of each VCSEL chip 101 can also be set to any other possible value according to actual needs.

In addition, the length of the first edge of the light emitting area of each VCSEL chip 101 can be adjusted according to actual needs. Generally, the length of the first edge can be greater than the length of the second edge. If the power of a single VCSEL chip 101 needs to be increased, the length of the first edge can be set larger.

The VCSEL chips 101 are arranged side by side along a first edge of the light emitting area, that is, they are arranged side by side along the length direction of the light emitting area.

For example, referring to FIG. 2 , as shown in FIG. 2 , a driving circuit QD is also packaged on the PCB 102 , and the driving circuit QD can supply power to each VCSEL chip 101. The driving circuit QD can also be connected to any power supply, and the power supply provides the driving circuit QD with a working voltage, which is not limited in the embodiment of the present application. Each VCSEL chip 101 includes a light emitting area 1011 and a wiring area 1012 , and a plurality of light emitting points can be distributed in the light emitting area 1011 . Direction x is the direction of the second edge of the light emitting area 1011 of each VCSEL chip 101 , and direction y is the direction of the first edge of the light emitting area 1011 of each VCSEL chip 101. That is to say, the two longer sides of the light emitting area 1011 are the first edges, and the two shorter sides of the light emitting area 1011 are the second edges. Specifically, in FIG. 2 , the two horizontal edges of the light emitting area 1011 are the first edges, and the two vertical edges are the second edges. It can be seen that the VCSEL chips 101 are arranged side by side along the first edge of the light emitting area 1011 and fixed on the PCB 102, and there is a certain distance between the VCSEL chips 101 , but they are not in direct contact.

The wiring area 1012 can represent the second pole of the VCSEL chip 101. Generally , the wiring area 1012 is used to connect the wires to the PCB 102. Specifically, a wire can be connected between the wiring area 1012 and the driving circuit QD to connect the second pole of the VCSEL chip 101 to the driving circuit QD of the PCB 102 .

It is worth noting that, when the driving circuit of PCB 102 supplies power to each VCSEL chip 101, each VCSEL chip 101 can be powered on to emit laser, and since each VCSEL chip 101 is arranged side by side along the first edge of the light emitting area, that is, arranged side by side along the length direction of the light emitting area, it can be ensured that the light emitting area of each VCSEL chip 101 in the line beam light source emitting device can form a longer light emitting area in the direction of the first edge, and emitting laser through this longer light emitting area can make the laser emitted by the line beam light source emitting device form a line spot , thereby achieving the purpose of emitting a line spot laser by the line beam light source emitting device, and since there are multiple VCSEL chips 101 arranged side by side in the line beam light source emitting device, in addition, since the divergence angle of the laser emitted by the line beam light source emitting device in the slow axis direction depends on the divergence angle of each VCSEL chip 101 itself , therefore, each VCSEL chip 101, the size of the first edge of the light emitting area of 101 does not affect the divergence angle of the laser emitted by the line light beam light source emitting device in the slow axis direction. Since the size of the first edge of a single VCSEL chip 101 is relatively small, generally 1 mm, each VCSEL chip 101 can be arranged side by side along the first edge of the light emitting area. In this way, it can also be ensured that the divergence angle of the laser emitted by the line light beam light source emitting device in the slow axis direction will not be affected, so that the power of the line light beam light source emitting device when emitting laser can be increased, and the high power of the line light beam light source emitting device can also be achieved. In addition, the power of the line light beam light source emitting device when emitting laser can be increased by increasing the number of VCSEL chips 101 arranged side by side, and the light emitting power of a single VCSEL chip 101 can be increased by increasing the length of the first edge of the light emitting area in each VCSEL chip 101, so as to further increase the power of the line light beam light source emitting device when emitting laser. The embodiment of the present application does not limit this.

It is worth noting that, since the spectral drift coefficient of the VCSEL chip 101 with temperature change is very small, generally only 0.07nm /°C, and in a wide temperature range, such as in the temperature range of (-40°C~110°C), the power attenuation of the VCSEL chip 101 is also low, generally less than 20% , and since the line light beam light source emitting device provided in the embodiment of the present application adopts the VCSEL chip 101 , the spectral drift coefficient of the line light beam light source emitting device with temperature change will be relatively small, and the power attenuation in a wide temperature range will also be low. In this way, the reliability of the line light beam light source emitting device can be improved, and the power attenuation can be reduced when the working environment temperature changes in a large range.

In addition, when the line light beam light source emitting device is used for distance detection, depth detection, and laser communication, a receiving device is required to receive the laser emitted by each VCSEL chip 101. Since the power attenuation of the line light beam light source emitting device is relatively low within a wide temperature range, the laser emitted by the line light beam light source emitting device can be received by a receiving device with lower precision. In this way, the versatility and universality of the line light beam light source emitting device can be improved.

It should be noted that the length of the second edge of the light emitting area of each VCSEL chip 101 is between 30 microns and 100 microns, and the diameter of each light emitting point is less than or equal to 33 microns. In this way, the light emitting size of each VCSEL chip 101 in the fast axis direction can be reduced, and the beam quality of the laser emitted by each VCSEL chip 101 in the fast axis direction can be improved. In addition, since the size of the second edge of each VCSEL chip 101 is reduced, the overall size of each VCSEL chip 101 can also be reduced, thereby reducing the cost of each VCSEL chip 101 .

In an embodiment of the present application, the line beam light source emitting device includes a plurality of VCSEL chips 101 and a PCB 102, and the PCB 102 includes a driving circuit. Each VCSEL chip 101 includes a light emitting area, and the light emitting area includes a plurality of light emitting points, and each light emitting point is used to emit laser. The light emitting area of each VCSEL chip 101 includes a first edge and a second edge. Each VCSEL chip 101 is arranged side by side along the first edge of the light emitting area and fixed on the PCB 102, and the first pole and the second pole of each VCSEL chip 101 are respectively connected to the driving circuit, and the driving circuit drives each VCSEL chip 101 to emit laser.

Among them, the first pole and the second pole of each VCSEL chip 101 can be connected to the driving circuit respectively, and each VCSEL chip 101 is connected through the driving circuit. When the first pole and the second pole of each VCSEL chip 101 are connected to the driving circuit, each VCSEL chip 101 can be connected to the driving circuit, and the driving circuit supplies power to each VCSEL chip 101, and the driving circuit can also control the duration, frequency, intensity and other parameters of the laser emitted by each VCSEL chip 101. Since the bottom surface of the VCSEL chip 101 is fixed on the top surface of the PCB 102, the first pole of each VCSEL chip 101 can be directly connected to the driving circuit in the PCB 102, so that the current conduction path can be shortened, and the parasitic inductance of each VCSEL chip 101 when working can be reduced, so that the line beam light source emitting device can obtain a short pulse width.

When the driving circuit of PCB 102 supplies power to each VCSEL chip 101, each VCSEL chip 101 can be powered on to emit laser light. Since each VCSEL chip 101 is arranged side by side along the first edge of the light emitting area, that is, arranged side by side along the length direction of the light emitting area, it can be ensured that the light emitting area of each VCSEL chip 101 in the line light beam light source emitting device can form a longer light emitting area in the direction of the first edge, and emitting laser light through this longer light emitting area can make the laser light emitted by the line light beam light source emitting device form a line light spot. Arranging each VCSEL chip 101 side by side along the first edge of the light emitting area can ensure that the divergence angle of the laser light emitted by the line light beam light source emitting device in the slow axis direction will not be affected, so that the power of the line light beam light source emitting device when emitting laser light can be increased, and the high power of the line light beam light source emitting device can also be achieved.

Since the spectral drift coefficient of the VCSEL chip 101 with temperature change is very small, and in a wide temperature range, the power attenuation of the VCSEL chip 101 is also low, generally less than 20% , and since the line light beam light source emitting device provided in the embodiment of the present application adopts the VCSEL chip 101 , the spectral drift coefficient of the line light beam light source emitting device with temperature change will be relatively small, and the power attenuation in a wide temperature range is also low. In this way, the reliability of the line light beam light source emitting device can be improved and the power attenuation can be reduced when the working environment temperature changes in a large range .

In addition, when the line light beam light source emitting device is used for distance detection, depth detection, and laser communication, a receiving device is required to receive the laser emitted by each VCSEL chip 101. Since the power attenuation of the line light beam light source emitting device is relatively low within a wide temperature range, the laser emitted by the line light beam light source emitting device can be received by a receiving device with lower precision, thereby improving the versatility and universality of the line light beam light source emitting device.

Device can be improved, and the power attenuation can be reduced when the working environment temperature varies in a large range. In addition, the versatility and universality of the line beam light source emitting device can also be improved.

In a possible implementation, based on FIG. 1 , referring to FIG. 3 , the line beam light source emitting device further includes a sub-heat sink 103 .

The sub-heat sink 103 is fixed on the PCB 102 , and each VCSEL chip 101 is arranged side by side and bonded on the sub-heat sink 103 along the first edge of the light emitting area.

The first electrode and/or the second electrode of each VCSEL chip 101 is connected to the driving circuit through the sub-heat sink 103 .

Optionally, the sub-heat sink 103 may be a DPC ceramic plate or a PCB plate, and the sub-heat sink 103 may be used to cool each VCSEL chip 101 and improve the heat dissipation capacity of each VCSEL chip 101. The sub-heat sink 103 may also be used to isolate the bottom of each VCSEL chip 101 from the top surface of the PCB 102 to prevent the temperature change of each VCSEL chip 101 from affecting the operation of the driving circuit of the PCB 102, or to prevent the temperature change of the driving circuit of the PCB 102 from affecting the operation of each VCSEL chip 101.

Optionally, the bottom surface of the sub-heat sink 103 may be bonded and fixed to the top surface of the PCB 102 by welding materials such as low-temperature solder or conductive glue, so as to fix the sub-heat sink 103 to the PCB 102. In addition, the bottom surface of each VCSEL chip 101 may be bonded and fixed to the top surface of the sub-heat sink 103 in sequence along the direction of the first edge of the light emitting area by welding materials such as low-temperature solder or conductive glue, so that each VCSEL chip 101 is arranged side by side and fixedly mounted on the sub-heat sink 103 along the first edge of the light emitting area.

The first electrode and/or the second electrode of each VCSEL chip 101 may be connected to the driving circuit by a flying wire passing through the sub-heat sink 103 or by a conductive component provided on the sub-heat sink 103 , which is not limited in the embodiment of the present application.

It is worth noting that, since the lower surface of each VCSEL chip 101 is bonded and fixed on the top surface of the sub-heat sink 103 along the first edge of the light emitting area, and the bottom surface of the sub-heat sink 103 is fixedly mounted on the top surface of the PCB 102, each VCSEL chip 101 can be fixed on the PCB 102 along the first edge of the light emitting area through the sub-heat sink 103, which can ensure that the divergence angle of the laser emitted by the line beam light source emitting device in the slow axis direction will not be affected, so that the power of the line beam light source emitting device when emitting laser can be increased, and the high power of the line beam light source emitting device can be achieved. In addition, the heat dissipation capacity of each VCSEL chip 101 can be improved, the temperature change of each VCSEL chip 101 can be prevented from affecting the operation of the driving circuit of PCB 102, and the temperature change of the driving circuit of PCB 102 can be prevented from affecting the operation of each VCSEL chip 101, and the reliability of the line beam light source emitting device can be further improved.

In a possible implementation, based on FIG. 3 , referring to FIG. 4 , the first surface of the sub-heat sink 103 has a plurality of pad groups, the sub-heat sink 103 also has a plurality of via groups, and the second surface of the sub-heat sink 103 abuts against the top surface of the PCB 102.

Each pad group includes a first pad 104 , each via group includes a first via hole, and each first via hole is provided with a first conductive channel D1 .

Each first via hole penetrates the sub-heat sink 103 , and a size of each first pad 104 is larger than a size of each first via hole.

Each first via hole is used to connect the first electrode of each VCSEL chip 101 to the circuit on the PCB 102 .

The number of each pad group is the same as the number of each VCSEL chip 101 , and the number of each via group is the same as the number of each pad group .

Optionally, the first surface may refer to a top surface of the sub-heat sink 103 , and the second surface may refer to a bottom surface of the sub-heat sink 103 .

The first pad 104 can be in various shapes such as star, triangle, rectangle, circle, etc. The size of the first pad 104 can be adjusted according to actual needs. Generally, the size of the first pad 104 can be slightly larger than the size of each VCSEL chip 101, which is not limited in the embodiment of the present application.

Each first via hole may also be in various shapes such as star, triangle, rectangle, circle, etc., which may be specifically adjusted according to the shape of the pins of each VCSEL chip 101 .

Optionally, each via group may include only one first via hole, or may include multiple first via holes, which may be adjusted according to actual needs, and is not limited in the embodiments of the present application.

In the case that each via hole group includes only one first via hole, the center of each first pad coincides with the center of each first via hole.

Each first pad 104 can be used to solder each VCSEL chip 101 so that each VCSEL chip 101 is fixed on the sub-heat sink 103. Each first pad 104 can also be used to connect with a soldering point provided on the top surface of the PCB 102 so that the sub-heat sink 103 is fixed on the PCB 102.

In addition, each first via hole can be used to insert a pin of each VCSEL chip 101, and can also be used to insert a first pole of each VCSEL chip 101. A wire can also be arranged in each first via hole to connect the first pole of each VCSEL chip 101 and the above-mentioned driving circuit, so that the first pole of each VCSEL chip 101 is connected to the driving circuit by flying wires from each first via hole.

Optionally, a first end of the first conductive channel D1 is connected to the first pad 104 and the first electrode of the VCSEL chip 101 respectively, and a second end of the first conductive channel D1 is connected to the top surface of the PCB 102 .

The first conductive channel D1 may be a copper foil, a copper column, a copper wire, or any other conductive channel made of a conductive material disposed in each first via hole 105 .

In addition, the second end of the first conductive channel D1 being connected to the top surface of the PCB 102 may specifically mean that the second end of the first conductive channel D1 is connected to a driving circuit printed on the top surface of the PCB 102 .

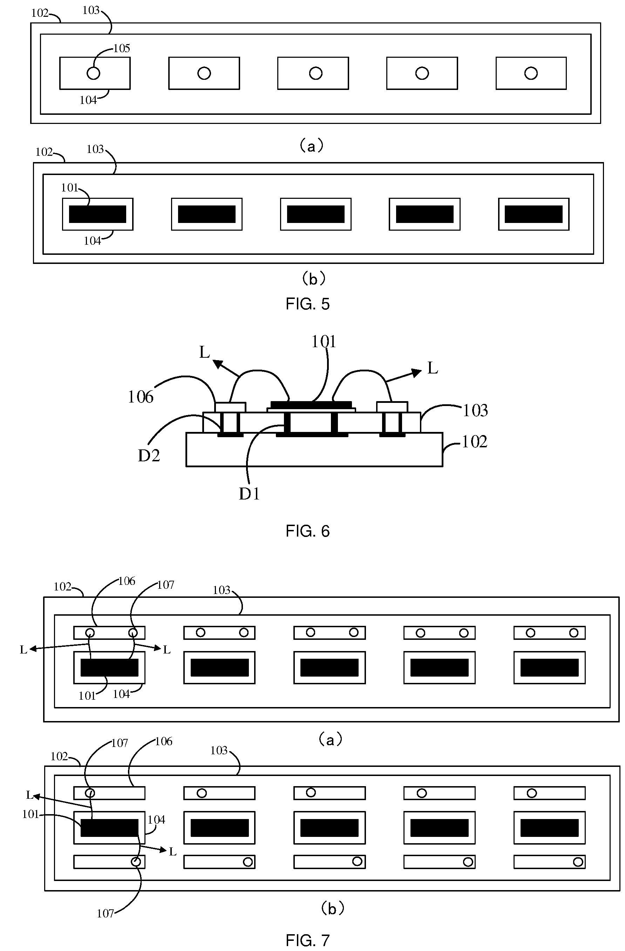

FIG. 5 is a schematic structural diagram of a VCSEL chip 101 , a sub-heat sink 103 , and a PCB 102 provided in an embodiment of the present application . As shown in (a) of FIG. 5 , at this time, each VCSEL chip 101 has not been mounted on the sub-heat sink 103 . It can be seen that the sub-heat sink 103 is mounted on the PCB 102 , and the sub-heat sink 103 includes a plurality of first pads 104 , and each first pad 104 has a corresponding first via hole 105 , and the first conductive channel D1 can be mounted in the first via hole 105 . Then, after each VCSEL chip 101 is fixedly mounted on the sub-heat sink 103, a structure as shown in (b) of FIG. 5 can be obtained. Specifically, the first electrode and / or pin of each VCSEL chip 101 can be connected to the first conductive channel D1 in each first via hole 105 , and then each VCSEL chip 101 can be bonded and fixed on the sub-heat sink 103 by injecting welding materials such as low-temperature solder or conductive glue into each first via hole 105 or welding the pin or welding point of each VCSEL chip 101 to each first pad 104 by welding materials such as low-temperature solder or conductive glue.

It is worth noting that, since the first conductive channel D1 is a channel made of conductive material, and the first end of the first conductive channel D1 is respectively connected to the first pad 104 and the first pole of the VCSEL chip 101, and the second end of the first conductive channel D1 is connected to the driving circuit on the top surface of the PCB 102, and the first conductive channel D1 and the first pad 104 are both conductive, then the first pole of the VCSEL chip 101 can be connected to the driving circuit through the first conductive channel D1. In addition, since the first conductive channel D1 is set in each first via hole 105, then it can directly penetrate the sub-heat sink 103 so that the first pole of the VCSEL chip 101 is connected to the driving circuit, so that the current conduction path can be shortened, and the parasitic inductance of each VCSEL chip 101 when working can be reduced, so that the line beam light source emitting device can obtain a short pulse width, and then the power attenuation of the line beam light source emitting device can be reduced when the working environment temperature changes in a large range .

In a possible implementation, referring to FIG. 6 , each pad group further includes at least one second pad 106 , each via group further includes at least one second via hole, and each second via hole is provided with a second conductive channel D2 .

Each second pad 106 is located at least on one side of the first pad 104 , and each second pad 106 is not connected to each first pad 104 .

Each second via hole penetrates the sub-heat sink 103 , and the size of each second pad 106 is larger than the size of each second via hole. Each second via hole is used to connect the second electrode of each VCSEL chip 101 to the circuit on the PCB 102 .

The second solder pad 106 may be in various shapes such as a star, a triangle, a rectangle, a circle, etc. The size of the second solder pad 106 may be adjusted according to actual needs, and each second via hole may also be in various shapes such as a star, a triangle, a rectangle, a circle, etc., which is not limited in the embodiments of the present application.

Optionally, each via group may include only one second via hole, or may include a plurality of second via holes, which may be adjusted according to actual needs, and is not limited in the embodiments of the present application.

In the case where each via hole group includes one second via hole, the center of each second pad 106 coincides with the center of each second via hole.

Each second solder pad 106 can be used to connect with a soldering point provided on the top surface of the PCB 102 so that the sub-heat sink 103 is fixed on the PCB 102. Since there are more soldering points between the sub-heat sink 103 and the PCB 102, the maximum pulling force or maximum pushing force that the sub-heat sink 103 and the PCB 102 can withstand can also be increased, thereby ensuring the stability of the sub-heat sink 103 fixed on the PCB 102.

In addition, a wire may be disposed in each second via hole to connect the second electrode of each VCSEL chip 101 and the driving circuit, so that the second electrode of each VCSEL chip 101 is connected to the driving circuit by flying wires through each second via hole.

Optionally, a first end of the second conductive channel D2 is connected to the second pad 106 and the second electrode of the VCSEL chip 101 , respectively, and a second end of the second conductive channel D2 is connected to the top surface of the PCB 102 .

The second conductive channel D2 may be a copper foil, a copper column, a copper wire or any other conductive channel made of a conductive material disposed in each second via hole.

the second conductive channel D2 being connected to the top surface of the PCB 102 may specifically mean that the second end of the second conductive channel D2 is connected to a driving circuit printed on the top surface of the PCB 102 .

As shown in FIG. 6 , the first end of the second conductive channel D2 is connected to the second pad 106 and the second electrode of the VCSEL chip 101 respectively, which can be specifically connected by The second electrode of the VCSEL chip 101, that is, the top surface of the VCSEL chip 101 is connected to the second pad 106 by a wire L in a flying wire manner, and the second conductive channel D2 and the second pad 106 are both conductive. In this way, the first end of the second conductive channel D2, the second pad 106 and the second electrode of the VCSEL chip 101 can be connected to each other.

Exemplarily, as shown in (a) of FIG. 7 , each second pad 106 is located on one side of the first pad 104 , the number of the second pads 106 is the same as the number of the first pads 104 , and each second pad 106 also includes two second via holes 107 , and the second conductive channel D2 can be installed in the second via holes 107 . As can be seen from (a) of FIG. 7 , a wire L can be arranged between the top surface of each VCSEL chip 101 and the second via hole 107 , that is, a wire L is arranged between the second pole of each VCSEL chip 101 and the second via hole 107 , so that the second pole of each VCSEL chip 101 is connected to the driving circuit.

For another example, as shown in (b) of FIG. 7 , each second pad 106 is respectively located on both sides of the first pad 104, and the number of the second pads 106 on each side is the same as the number of the first pads 104, and each second pad 106 also includes a second via hole 107, and the second conductive channel D2 can be installed in the second via hole 107. As can be seen from (b) of FIG. 7 , a wire L can also be arranged between the second electrode of each VCSEL chip 101 and the second via hole 107, so that the second electrode of each VCSEL chip 101 is connected to the driving circuit.

It is worth noting that, since the second conductive channel D2 is a channel made of conductive material, and the first end of the second conductive channel D2 is respectively connected to the second pad 106 and the first pole of the VCSEL chip 101, and the second end of the second conductive channel D2 is connected to the driving circuit on the top surface of the PCB 102, and the second conductive channel D2 and the second pad 106 are both conductive, then the second pole of the VCSEL chip 101 can be connected to the driving circuit through the second conductive channel D2 . Since the lower surface of each VCSEL chip 101 is fixed on the top surface of the sub-heat sink 103 , it is necessary to fly a wire between the second pole of each VCSEL chip 101 and the driving circuit to bypass the sub-heat sink 103 so that the second pole of each VCSEL chip 101 can be connected to the driving circuit. However, the second conductive channel D2 is set in each second via hole 107. Then, only a short section of wire L is needed to connect the second pole of the VCSEL chip 101 to the second pad 106 and / or the second conductive channel D2 , and then it can directly penetrate the sub-heat sink 103 to connect the second pole of the VCSEL chip 101 to the driving circuit. In this way, the current conduction path can be shortened, and the parasitic inductance of each VCSEL chip 101 when working can be reduced, so that the line beam light source emitting device can obtain a short pulse width.

In a possible implementation, the sub-heat sink 103 is fixed on the PCB 102 via welding points disposed on the top surface of the PCB 102 .

Optionally, multiple welding points can be set on the top surface of PCB 102 to weld the ground of the sub-heat sink 103 and the top surface of PCB 102, so as to increase the maximum pulling force or maximum pushing force that the sub-heat sink 103 and PCB 102 can withstand, thereby ensuring the stability of the sub-heat sink 103 fixed to the PCB 102.

In a possible implementation, welding points corresponding to the first pads 104 and the second pads 106 are disposed on the top surface of the PCB 102 , and each welding point is connected to the driving circuit.

It is worth noting that, since each welding point on the top surface of the PCB 102 can be connected to the driving circuit, and each welding point corresponds to each first welding pad 104 and each second welding pad 106, then, that is, when the sub-heat sink 103 is fixed on the PCB 102 through each welding point, each welding point is welded with the corresponding first welding pad 104 and each second welding pad 106, and since each first welding pad 104 and each second welding pad 106 correspond to the first conductive channel D1 and the second conductive channel D2 respectively , then the first electrode of each VCSEL chip 101 can be directly electrically connected to the welding point on the PCB through each first welding pad 104 and each second welding pad 106, that is, the first electrode of each VCSEL chip 101 can be directly electrically connected to the welding point on the PCB through the first conductive channel D1 and the second conductive channel D2 , so that the current conduction path can be shortened, and the parasitic inductance of each VCSEL chip 101 when working can be reduced, so as to obtain a short pulse width.

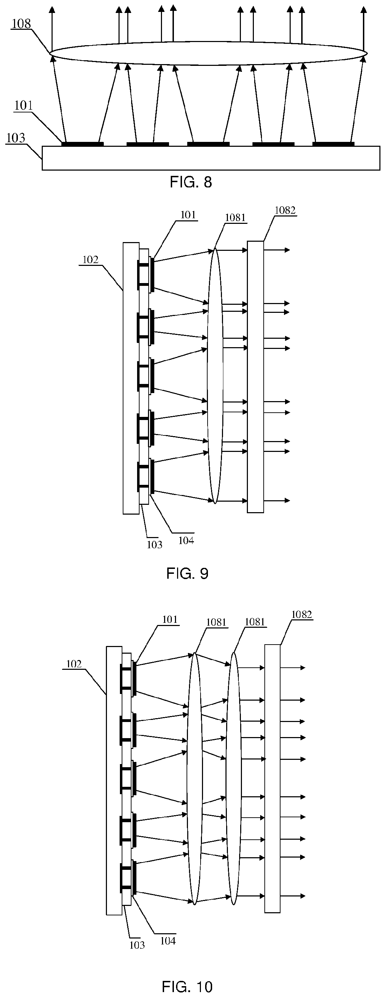

In a possible manner, referring to FIG. 8 , the device further includes an optical shaping module 108 .

The optical shaping module 108 is disposed at one side of the light emitting area of each VCSEL chip 101 , and is used to shape the laser light emitted by each VCSEL chip 101 in the first direction and/or the second direction.

Optionally, the first direction is perpendicular to the second direction. Generally, the first direction may also refer to the slow axis direction of the optical shaping module 108, and the second direction may refer to the fast axis direction of the optical shaping module 108. Specifically, the slow axis direction of the optical shaping module 108 is defined as being parallel to the direction of the first edge of the light emitting area of each VCSEL chip 101, and the fast axis direction of the optical shaping module 108 is defined as being parallel to the direction of the second edge of the light emitting area of each VCSEL chip 101.

In addition, when the direction of the second edge of the light emitting area of each VCSEL chip 101 is perpendicular to the horizontal plane, the first direction may refer to the horizontal direction, and the second direction may refer to the vertical direction, which is not limited in the embodiment of the present application.

Optionally, shaping the laser light emitted by each VCSEL chip 101 may specifically refer to collimating and homogenizing the laser light emitted by each VCSEL chip 101. This embodiment of the present application does not limit this.

Optionally, the optical shaping module 108 can be specifically used to collimate the laser emitted from the light emitting area of each VCSEL chip 101 in the first direction, and to homogenize the laser emitted from the light emitting area of each VCSEL chip 101 in the second direction, so that the laser emitted by the optical shaping module 108 forms a line spot.

It is worth noting that, since the optical shaping module 108 is arranged on one side of the light emitting area of each VCSEL chip 101, the laser emitted by each VCSEL chip 101 can be emitted into the optical shaping module 108, and the laser emitted by the light emitting area of each VCSEL chip 101 is collimated by the optical shaping module 108 in the first direction, and the laser emitted by the light emitting area of each VCSEL chip 101 is homogenized in the second direction, so that the lasers emitted by the optical shaping module 108 can be kept parallel, and the light intensity of each part of the emitted line spot can be similar, that is, the laser emitted by the line beam light source emitting device through the optical shaping module 108 can form a line spot with a better effect.

In addition, since the length of the second edge of the light emitting area of each VCSEL chip 101 is between 30 microns and 100 microns , and the diameter of each light emitting point is less than or equal to 33 microns, when the laser is emitted into the optical shaping module 108, the optical shaping module 108 shapes the laser in the fast axis direction, that is, in the second direction, to obtain a narrower line spot, thereby improving the quality of the line spot emitted by the line beam light source emitting device.

In a possible implementation, the optical shaping module 108 may include a collimating lens group and a homogenizing lens.

The collimating lens group and the homogenizing lens may both be installed on one side of the light emitting area of each VCSEL chip 101 .

The distance between the collimating lens group and the light emitting area of each VCSEL chip 101 may be smaller than the distance between the homogenizing lens and the light emitting area of each VCSEL chip 101.

the divergence angle of the laser emitted by each light emitting point in the first direction less than or equal to 0.3°.

The homogenizing lens is used to homogenize the laser light emitted from each light emitting point at an angle of 10° to 30° in the second direction.

Exemplarily, the following four methods can be used to collimate and homogenize the laser light emitted by each VCSEL chip 101 in the first direction and the second direction.

The first method, see FIG. 9 , the collimating lens group may include a collimating lens 1081, and the homogenizing lens may be a homogenizing lens 1082. As shown in FIG. 9 , this solution uses a collimating lens 1081 in the fast axis direction to adjust the divergence angle of the laser emitted by each VCSEL chip 101 to <0.3°, and uses a homogenizing lens 1082 in the slow axis direction to achieve a homogenization effect of 10°-30° on the laser emitted from the homogenizing lens 1082. Specifically, the laser emitted by each VCSEL chip 101 first enters the collimating lens 1081, and then the laser entering the homogenizing lens 1082 is the light whose divergence angle is adjusted to <0.3° by the collimating lens 1081 , and then after the homogenization effect of 10°-30° is achieved by the homogenizing lens 1082, it can be ensured that the final emitted laser is a line spot .

The minimum homogenization angle achieved by the homogenization lens 1082 in the slow axis direction is the divergence angle of each VCSEL chip 101 , and the maximum homogenization angle can be determined by the numerical aperture of the homogenization lens 1082. This solution is relatively simple and uses fewer lenses, which can reduce the cost of the line beam light source emitting device.

The second method, see FIG. 10 , the collimating lens group may include two collimating lenses 1081, and the homogenizing lens may be a homogenizing lens 1082. As shown in FIG. 10 , this solution uses two collimating lenses 1081 in the fast axis direction to adjust the divergence angle of the laser emitted by each VCSEL chip 101 to <0.3°. Since two collimating lenses 1081 are used, the laser emitted by each VCSEL chip 101 needs to be injected into two collimating lenses 1081 at a time, and then injected into the homogenizing lens 1082 to achieve the homogenization effect, which can ensure that the final emitted laser is a linear spot. In this way, not only a better collimation effect can be achieved, but also the effect of compressing the optical path can be achieved through further focusing of the two collimating lenses 1081. That is to say, when the light beam is collimated by two collimating lenses 1081, a better collimation effect and the effect of compressing the optical path can be achieved within a shorter focal length.

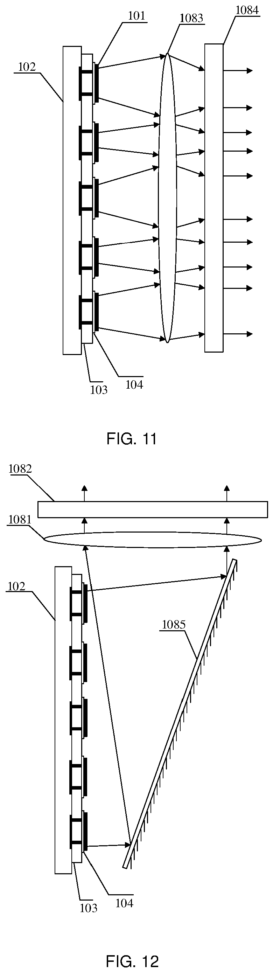

The third method, see FIG. 11 , the collimating lens group may include a collimating lens 1083, the homogenizing lens may be a homogenizing lens 1084, the collimating lens 1083 may be used only to achieve the purpose of optical path compression, and the homogenizing lens 1084 may be a lens with an aspheric surface in the straight generatrix direction of the microcylinder. As shown in FIG. 11 , when the laser emitted by each VCSEL chip 101 enters the collimating lens 1083, the collimating lens 1083 only plays the role of compressing the optical path, while the homogenizing lens 1084 can simultaneously achieve the effects of collimation in the fast axis direction and homogenization in the slow axis direction for the laser that enters the homogenizing lens 1084 through the collimating lens 1083, and can ensure that the laser finally emitted is a linear spot. In this way, the effects of collimation, optical path compression, and homogenization can also be achieved simultaneously.

The fourth method, referring to FIG. 12 , the optical shaping module 108 may further include a reflector 1085, the collimating lens group may include a collimating lens 1081, and the homogenizing lens may be a homogenizing lens 1082, as shown in FIG. 12 . In this scheme, the plane where the optical shaping module 108 is located may be perpendicular to the plane where each VCSEL chip 101 is located. Specifically, the optical path of the laser emitted by each VCSEL chip 101 is first changed by the reflector 1085, and the laser emitted by each VCSEL chip 101 is reflected into the collimating lens 1081. The laser then enters the homogenizing lens 1082 is the laser emitted by each VCSEL chip 101. The divergence angle of the laser is adjusted to <0.3° by the collimating lens 1081 , and then the homogenizing effect of 10°-30° is achieved by the homogenizing lens 1082, so that the final emitted laser is a line spot. In this way, the optical path of the laser can be changed by the reflector 1085, and the distance of laser propagation in the process of collimating and homogenizing the laser can be shortened. Therefore, the volume of the optical shaping module 108 can be reduced, and then the volume of the line beam light source emitting device can be reduced.

In a possible implementation, the first electrode of each VCSEL chip 101 is connected to a first common point on the driving circuit, and the second electrode of each VCSEL chip 101 is connected to a second common point on the driving circuit.

In this case, each VCSEL chip 101 can be connected to the driving circuit, and each VCSEL chip 101 is connected in parallel.

It is worth noting that by connecting the VCSEL chips 101 in parallel, the series resistance and parasitic inductance in the loop formed by the VCSEL chips 101 can be reduced, thereby reducing the pulse width and rise time in the line beam light source emitting device.

In a possible implementation, a first electrode of the first VCSEL chip 101 and a second electrode of the second VCSEL chip 101 are connected to a third common point on the driving circuit, so that the first VCSEL chip 101 and the second VCSEL chip 101 are connected in series.

Optionally, the first VCSEL chip 101 and the second VCSEL chip 101 are two adjacently arranged VCSEL chips 101 among the VCSEL chips 101 .

In this case, each VCSEL chip 101 may also be connected to the driving circuit, and each VCSEL chip 101 is connected in series.

In addition, when short-pulse laser detection is realized by using the line beam light source emitting device provided in the embodiment of the present application, such as depth detection and distance detection, the pulse width needs to be very small, so the VCSEL chips 101 can be connected in parallel.

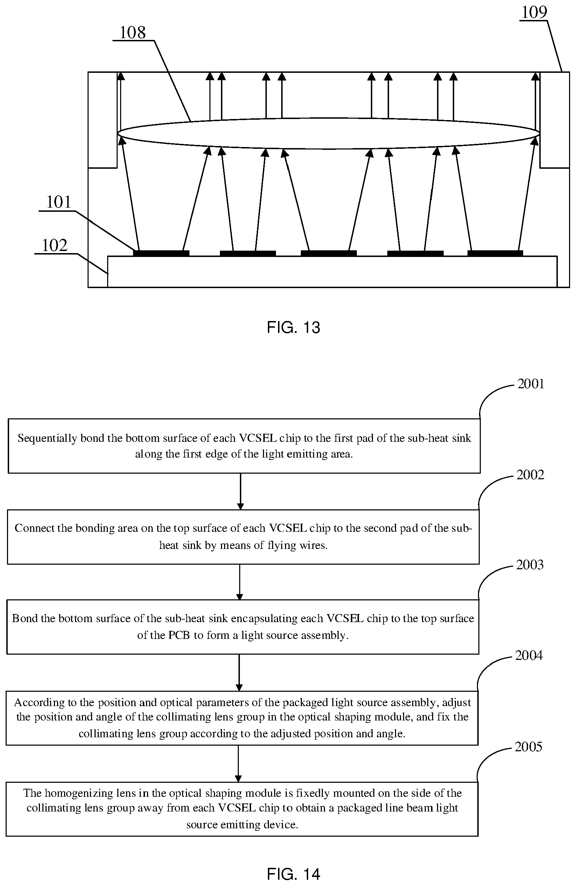

FIG. 13 is a schematic structural diagram of a line light beam light source emitting device provided in an embodiment of the present application. Referring to FIG. 13 , the line light beam light source emitting device includes a shell 109 and a line light beam light source emitting device in each method embodiment.

Optionally, the shell 109 is used to fix the line beam light source emitting device.

Optionally, the structure of the shell 109 can be any structure that can fix the line beam light source emitting device. The structure of the shell 109 shown in FIG. 13 is merely an example, and does not mean that the shell 109 in the line beam light source emitting device provided in the embodiment of the present application can only be the structure of the shell 109 shown in FIG. 12 .

FIG. 14 is a flow chart of a packaging method of a line beam light source emitting device provided in an embodiment of the present application. Referring to FIG. 14 , the method includes:
Step 2001 : Sequentially bond the bottom surface of each VCSEL chip to the first pad of the sub-heat sink along the first edge of the light emitting area.

Optionally, the first electrode of each VCSEL chip is located at the bottom surface of each VCSEL chip. Then, after the bottom surface of each VCSEL chip is bonded to the first pad of the sub-heat sink along the first edge of the light emitting area in sequence, the first electrode of each VCSEL chip contacts the first pad.

The sub-heat sink is further provided with a first conductive channel in the first via hole, and the first conductive channel is connected to the first pad, and the first electrode of each VCSEL chip is also connected to the first conductive channel.

Exemplarily, the bottom surface of each VCSEL chip may be bonded to the first pad of the sub-heat sink in sequence according to a preset position.

For example, the preset position may refer to a position that ensures that after each VCSEL chip is bonded to each first pad, the position error between each VCSEL chip is less than or equal to a position error threshold, and the angle error between each VCSEL chip is less than or equal to an angle error threshold.

The position error may refer to the distance error between each VCSEL chip on the three axes X, Y, and Z. The three axes X, Y, and Z are perpendicular to each other. Generally, the plane where the X and Y axes are located may be a plane parallel to the top and/or bottom surface of each VCSEL chip, and the Z axis may be perpendicular to the plane where the X and Y axes are located, that is, the Z axis may be perpendicular to the top and/or bottom surface of each VCSEL chip. This embodiment of the application does not limit this.

Pitch of each VCSEL chip rotating around the X axis , the yaw angle (Yaw) of each VCSEL chip rotating around the Y axis, and the roll angle (Roll) of each VCSEL chip rotating around the Z axis . Generally, the three plane angles formed by the three axes X, Y, and Z can be used as reference angles, which are not limited in the embodiments of the present application.

The position error threshold and the angle error threshold can be set by relevant technical personnel according to actual needs, and the embodiments of the present application do not limit this.

It is worth noting that, generally, the position error threshold and the angle error threshold can be as small as possible, so as to ensure that when each VCSEL chip is bonded to each first pad, the position error between each VCSEL chip on the three axes of X, Y, and Z is small, and the errors between the pitch angle, yaw angle, and roll angle of each VCSEL chip relative to the three axes of X, Y, and Z are small. In this way, the quality of the line spot emitted by the line beam light source emitting device can be improved.

In addition, since the bottom surfaces of the VCSEL chips are sequentially bonded to the first pad of the sub-heat sink along the first edge of the light emitting area, that is, they are arranged side by side along the length direction of the light emitting area, it can be ensured that the light emitting areas of the VCSEL chips in the line beam light source emitting device can form a longer light emitting area in the direction of the first edge, and emitting laser through this longer light emitting area can make the laser emitted by the line beam light source emitting device form a line spot, thereby achieving the purpose of the line beam light source emitting device emitting a line spot laser, and since a plurality of VCSEL chips are arranged side by side in the line beam light source emitting device, the power of the line beam light source emitting device when emitting laser can be increased, and thus the high power of the line beam light source emitting device can be achieved.

Step 2002 : Connect the wiring area on the top surface of each VCSEL chip to the second pad of the sub-heat sink by means of flying wires.

Optionally, the wiring area 1012 can represent the second pole of the VCSEL chip 101. Then , the wiring area on the top surface of each VCSEL chip is connected to the second pad of the sub-heat sink by flying wires, that is, the second pole of the VCSEL chip 101 is connected to the second pad of the sub-heat sink.

The sub-heat sink is further provided with a second conductive channel in the second via hole, and the second conductive channel is connected to the second pad, so the second electrode of each VCSEL chip is also connected to the second conductive channel.

It is worth noting that, since each second conductive channel passes through the sub-heat sink through the second via hole, and each second conductive channel is connected to the second pad, then by connecting the wiring area on the top surface of each VCSEL chip to the second pad of the sub-heat sink by flying wires, the second pole of each VCSEL chip and the driving circuit can be directly connected through the sub-heat sink. In this way, the current conduction path can be shortened, and the parasitic inductance of each VCSEL chip 101 when working can be reduced, so that the line beam light source emitting device can obtain a short pulse width.

Step 2003 : Bond the bottom surface of the sub-heat sink encapsulating each VCSEL chip to the top surface of the PCB to form a light source assembly.

Optionally, the light source assembly includes VCSEL chips, a PCB, and a sub-heat sink.

When the bottom surface of the sub-heat sink encapsulating each VCSEL chip is bonded to the top surface of the PCB, the second end of the first conductive channel in the sub-heat sink is connected to the top surface of the PCB, that is, the second end of the first conductive channel is connected to the driving circuit printed on the top surface of the PCB. In addition, the second end of the first conductive channel in the sub-heat sink is connected to the top surface of the PCB, that is, the second end of the first conductive channel is connected to the driving circuit printed on the top surface of the PCB.
each VCSEL chip is also connected to the first conductive channel, and the second electrode of the VCSEL chip 101 is connected to the second pad of the sub-heat sink. In this way, the first electrode of each VCSEL chip and the second electrode of each VCSEL chip can be connected to the driving circuit printed on the top surface of the PCB.

It is worth noting that, since the first conductive channel is located in each first via hole, and each first via hole passes through the sub-heat sink, after the bottom surface of the sub-heat sink encapsulating each VCSEL chip is bonded to the top surface of the PCB, the second surface of the sub-heat sink abuts against the top surface of the PCB, so that the first pole of each VCSEL chip can be connected to the driving circuit through the first conductive channel, so that the current conduction path can be shortened, and the parasitic inductance of each VCSEL chip when working can be reduced, so that the line beam light source emitting device can obtain a short pulse width, and further can achieve the effect of reducing the power attenuation of the line beam light source emitting device when the working environment temperature varies widely .

Step 2004 : According to the position and optical parameters of the packaged light source assembly, adjust the position and angle of the collimating lens group in the optical shaping module, and fix the collimating lens group according to the adjusted position and angle.

Optionally, the optical parameters may include the divergence angle of the laser emitted by each VCSEL chip and any other parameters that may be required when adjusting the position and angle of the collimating lens group in the optical shaping module.

Generally, the optical shaping module is arranged on one side of the light emitting area of each VCSEL chip.

Adjusting the position and angle of the collimating lens group may specifically refer to adjusting the distance between the collimating lens group and the emission area of each VCSEL chip and the angle between the collimating lens group and the emission area of each VCSEL chip to adjust the appropriate focal length, thereby ensuring that the collimating lens group can adjust the divergence angle of the laser emitted by each VCSEL chip 101 to <0.3° at the adjusted position and angle .

In this way, since the optical shaping module is arranged on one side of the light emitting area of each VCSEL chip, the laser emitted by each VCSEL chip can be emitted into the collimating lens group in the optical shaping module, and the laser emitted by the light emitting area of each VCSEL chip is collimated in the first direction through the collimating lens group in the optical shaping module. In this way, the quality of the line spot emitted by the line beam light source emitting device through the optical shaping module can be improved.

Step 2005 : The homogenizing lens in the optical shaping module is fixedly mounted on the side of the collimating lens group away from each VCSEL chip to obtain a packaged line beam light source emitting device.
the position where the homogenizing lens is fixedly installed can be determined according to the distance between the collimating lens group and the homogenizing lens . Generally, the position where the homogenizing lens is fixedly installed can be a position where the laser incident on the homogenizing lens 1082 is homogenized at an angle of 10°-30°, or a position where the laser finally emitted is a linear spot.

It is worth noting that, since the homogenizing lens in the optical shaping module is fixedly mounted on the side of the collimating lens group away from each VCSEL chip, the collimated laser emitted by the collimating lens group can be emitted into the homogenizing lens in the optical shaping module, and the laser emitted from the light emitting area of each VCSEL chip in the second direction is homogenized by the homogenizing lens in the optical shaping module, so that the lasers emitted by the optical shaping module can be kept parallel, and the light intensity of each part of the emitted line spot can be similar, so that the quality of the line spot emitted by the line beam light source emitting device through the optical shaping module can be improved.

The implementation principle and technical effect of the packaging method of the above-mentioned line beam light source emitting device are similar to those of the line beam light source emitting device provided in the aforementioned embodiment and will not be described in detail here.

The above is only a specific implementation of the present application, but the protection scope of the present application is not limited thereto. Any technician familiar with the technical field can easily think of changes or substitutions within the technical scope disclosed in the present application, which should be included in the protection scope of the present application. Therefore, the protection scope of the present application should be based on the protection scope of the claims.

The above description is only the preferred embodiment of the present application and is not intended to limit the present application. For those skilled in the art, the present application may have various modifications and variations. Any modification, equivalent replacement, improvement, etc. made within the spirit and principle of the present application shall be included in the protection scope of the present application.

## Claims

1. A line beam light source emitting device, **characterized in that**, the device comprises a plurality of vertical cavity surface emitting laser chips and a circuit board, wherein the circuit board comprises a driving circuit,
each of the vertical cavity surface emitting laser chips includes a light emitting area, the light emitting area includes a plurality of light emitting points, and each of the light emitting points is used to emit laser light,
the light emitting area of each of the vertical cavity surface emitting laser chips comprises a first edge and a second edge, and the length of the first edge is greater than the length of the second edge,
each of the vertical cavity surface emitting laser chips is arranged side by side along a first edge of the light emitting area and fixed on the circuit board. The first pole and the second pole of each of the vertical cavity surface emitting laser chips are respectively connected to the driving circuit, and the driving circuit drives each of the vertical cavity surface emitting laser chips to emit laser.

2. The line beam light source emitting device according to claim 1, **characterized in that**, the light emitting area of each of the vertical cavity surface emitting laser chips is a rectangular area.

3. The line beam light source emitting device according to claim 1, **characterized in that**, the device further comprises a sub-heat sink,
the sub-heat sink is fixed on the circuit board, and each of the vertical cavity surface emitting laser chips is arranged side by side along the first edge of the light emitting area and bonded to the sub-heat sink,
the first pole and/or the second pole of each of the VCSEL chips is connected to the driving circuit through the sub-heat sink.

4. The line beam light source emitting device according to claim 3, **characterized in that**, the first surface of the sub-heat sink has a plurality of pad groups, the sub-heat sink also has a plurality of via groups, and the second surface of the sub-heat sink abuts against the top surface of the circuit board,
each of the pad groups includes a first pad, each of the via groups includes a first via hole, and each of the first via holes is provided with a first conductive channel,
each of the first via holes passes through the sub-heat sink, and the size of each of the first pads is larger than the size of each of the first via holes; each of the first via holes is used to connect the first pole of each of the vertical cavity surface emitting laser chips to the circuit on the circuit board.

5. The line beam light source emitting device according to claim 4, **characterized in that**, each of the pad groups further comprises at least one second pad, each of the via groups further comprises at least one second via hole, and each of the second via holes is provided with a second conductive channel,
each of the second pads is located at least on one side of the first pad, and each of the second pads is not connected to each of the first pads,
each of the second via holes passes through the sub-heat sink, a size of each of the second pads is larger than a size of each of the second via holes, and each of the second via holes is used to connect the second pole of each of the vertical cavity surface emitting laser chips to the circuit on the circuit board.

6. The line beam light source emitting device according to claim 1, **characterized in that**, the device further comprises an optical shaping module,
the optical shaping module is arranged at one side of the light emitting area of each of the vertical cavity surface emitting laser chips and is used to collimate and/or homogenize the laser emitted by each of the vertical cavity surface emitting laser chips in a first direction and/or a second direction, wherein the first direction is perpendicular to the second direction.

7. The line beam light source emitting device according to any one of claims 1 to 6, **characterized in that**, a first pole of each of the vertical cavity surface emitting laser chips is connected to a first common point on the driving circuit, and a second pole of each of the vertical cavity surface emitting laser chips is connected to a second common point on the driving circuit.

8. The line beam light source emitting device according to any one of claims 1 to 6 , **characterized in that**, the first pole of the first vertical cavity surface emitting laser chip and the second pole of the second vertical cavity surface emitting laser chip are connected to a third common point on the driving circuit, so that the first vertical cavity surface emitting laser chip and the second vertical cavity surface emitting laser chip are connected in series, wherein the first vertical cavity surface emitting laser chip and the second vertical cavity surface emitting laser chip are two adjacently arranged vertical cavity surface emitting laser chips among the vertical cavity surface emitting laser chips.

9. The line beam light source emitting device according to any one of claims 1 to 6 , **characterized in that**, the length of the second edge of the light emitting area of each vertical cavity surface emitting laser chip is greater than or equal to 30 microns and less than or equal to 100 microns.

10. A line beam light source emitting device, **characterized in that**, the device comprises a shell and the line beam light source emitting device according to any one of claims 1 to 9, wherein the shell is used to fix the line beam light source emitting device.
